# EUROPEAN PATENT APPLICATION

(11) **EP 0 552 920 A1**
(43) Date of publication of application: **28.07.1993**
(21) Application number: 93300341.0
(22) Date of filing: 19.01.1993
(51) Int. Cl.: H05K 13/04

(54) **Tool holder for surface mount machine**

(30) Priority: 21.01.1992 US 823195
(71) Applicant: EMHART INC., Newark, Delaware 19711 (US)
(72) Inventor: Rossmeisl, Mark E., Beverly, Massachusetts 01915 (US)
(74) Representative: Stagg, Diana Christine

(57) **Abstract**

A machine for placing surface mount electronic components on a printed circuit board comprising a tool holder 16 for supporting a tool to hold a component. The machine further comprises a shaft rotatable 60 about and displaceable downwardly along its axis, means 59, 70 for interconnecting the shaft 60 and the tool holder 16 for conjoint rotational displacement, and means 65 for interconnecting the shaft 60 and the tool holder 16 for conjoint downward displacement until a component held by a tool supported by the tool holder 16 forcefully engages the printed circuit board and for relative axial displacement as the tool holder 16 is further displaced downwardly, means for defining a volume axially separating the shaft 60 and the tool holder 16 that can be reduced by the, downward axial displacement of the shaft 60 relative to the tool holder 16, and means for maintaining a selected pressure in the volume during the downward displacement of the shaft 60 relative to the tool holder 16 when a component forcefully engages the circuit board.

## Description

The present invention relates to a machine for placing surface mount components on printed circuit boards.

Conventionally, surface mount electronic components are picked up by engaging the top flat surface of the component with a vacuum tool. The feed stroke of the tool holder is controlled precisely but the location of the top surface of the component may vary for a variety of reasons, including board warpage.

It is accordingly an object of the present invention to provide a tool holder that will automatically compensate for such variations.

The present invention provides a machine for placing surface mount electronic components on a printed circuit board comprising a tool holder for supporting a tool to hold a component, a shaft rotatable about and displaceable downwardly along its axis, means for interconnecting the shaft and the tool holder for conjoint rotational displacement, means for interconnecting the shaft and the tool holder for conjoint downward displacement until a component held by a tool supported by the tool holder forcefully engages the printed circuit board and for relative axial displacement as the tool holder is further displaced downwardly, means for defining a volume axially separating the shaft and the tool holder that can be reduced by the downward axial displacement of the shaft relative to the tool holder, and means for maintaining a selected pressure in the volume during the downward displacement of the shaft relative to the tool holder when a component forcefully engages the circuit board.

An embodiment of a machine according to the invention will now be further described with reference to the accompanying drawings in which,
Figure 1 is an elevational cross sectional view of a tool head assembly of a machine for placing surface mount electronic components on printed circuit boards; and
Figure 2 is a view on line 2-2 of Figure 1.

A printed circuit board 10 to be populated with surface mount components 12, is supported on a slide (not shown for horizontal displacement and a tool head assembly 14 which is also supported for horizontal displacement, is vertically displaceable and rotatable about its axis to place the components on the printed circuit board. The tool head assembly 14 includes a tool holder 16 and a tool 18. The tool holder has an interior vacuum line 20 which communicates with an outwardly tapered, conical port 22. A similarly tapered head 24 of the tool 18 is matingly received by this tapered port 22 and forced engagement therebetween is achieved by a plurality (three) of detents 26, each being shaped like a rivet having a head 27, a cylindrical body 28 and a spherical end 30, which are urged inwardly by an elastic band 32 against the arcuate, annular surface 34 connecting the tapered head 24 to a reduced diameter portion 36. The middle portion 38 of the tool 18 is cylindrical and has an annular circumferential groove 40. The tool ends with a tip 42 for engaging the component 12. The tool holder vacuum line 20 connects a vacuum conduit 46 in the tool with an annular groove 48 in the tool holder which communicates with one of the inlet lines 50 of a union 52. A second inlet line 54 communicates via an annular tool holder groove 55 and conduit 56 with a blind central bore 58 which receives a preloaded ball spline nut 59 operatively connected to a ball spline or shaft 60. This permits relative axial movement between the ball spline nut and the shaft while joining them for conjoint rotational displacement. Further details of the ball spline and ball spline nut are disclosed in U.S. Patent No. 4,799,803. When the surface of the circuit board is properly located, downward movement of the shaft will gently place the component. If, however, the surface is too high, the component will be place before the shaft is fully down. The tool holder 16 can then stop its downward movement avoiding damage to the component and the shaft can finish its downward displacement by compressing the air within the volume defined by bore 58. Three sealing rings 62 establish a seal on either side of the annular grooves 48, 55 and a fourth sealing ring 64 which is supported by a cylindrical disc 65 secured via a screw 66 to the shaft 60 establishes a seal between the tool holder shaft 60 and the central bore 58.

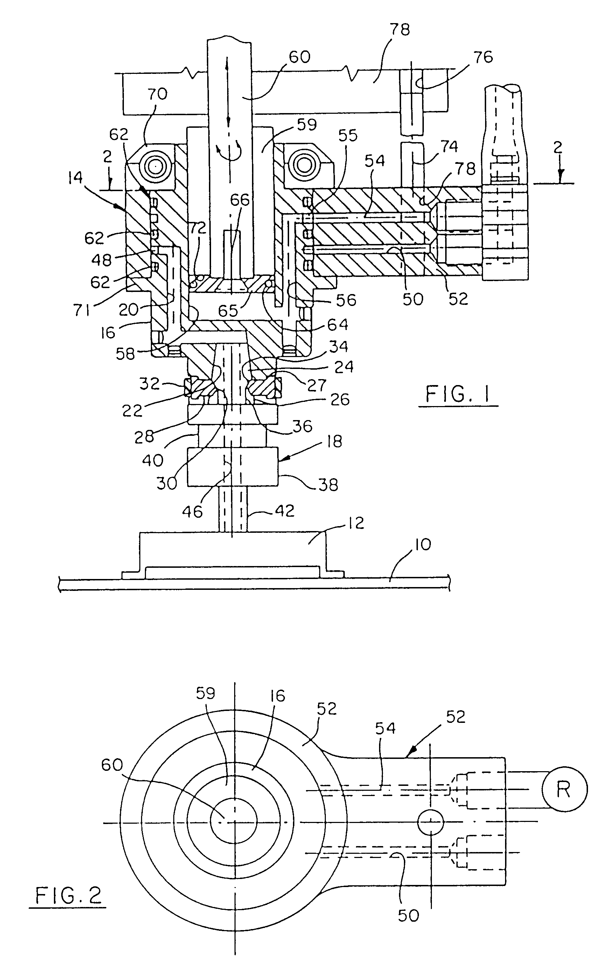

A clamping collar 70 secures the ball nut 59 to the tool holder 16 and locates the union 52 in the desired location between the tool holder flange 71 and the collar 70. Compliant relative axial movement can then occur between the tool holder shaft 60 and the tool holder to compensate for variations in tool holder axial position whether due to board warpage or otherwise. The bottom surface 72 of the ball nut 59 functions as the upward stop for the disc 65 and hence the tool shaft 60. Rotary union 52 is prevented from rotation by a sliding pin 74 which is secured to the rotary union and which is slidably received by a suitable hole 76 in the frame 78. Compressed air to the central bore can be programmably regulated to allow selected compliant pressure. A source of regulated compressed air R is shown in Figure 2.

## Claims

1. A machine for placing surface mount electronic components on a printed circuit board comprising
a tool holder 16 for supporting a tool to hold a component , characterised in that the machine further comprises
a shaft 60 rotatable about and displaceable downwardly along its axis;
means 59, 70 for interconnecting the shaft 60 and the tool holder 16 for conjoint rotational displacement, and
means 65 for interconnecting the shaft 60, and the tool holder 16 for conjoint downward displacement until a component held by a tool supported by the tool holder 16 forcefully engages the printed circuit board and for relative axial displacement as the tool holder 16 is further displaced downwardly.
means 58 for defining a volume axially separating the shaft 60 and the tool holder 16 that can be reduced by the downward axial displacement of the shaft 60 relative to the tool holder 16, and
means R for maintaining a selected pressure in the volume during the downward displacement of the shaft 60 relative to the tool holder 16 when a component forcefully engages the circuit board.

2. A machine according to claim 1, characterised in that the shaft 60 is a ball spline 60 and the interconnecting means 65 comprises a ball spline nut 59.

3. A machine according to claim 2 characterised in that the tool holder 16 includes a blind bore 64 for receiving the ball spline nut 59 and further comprising means 70 for clamping the ball spline nut 59 to the tool holder 16.

4. A machine according to any of claims 1 to 3, characterised in that the tool holder 16 comprises
a cylindrical outer surface having an annular groove 55 and conduit means 56 extending between the volume and the outer surface, and
a rotary union 52 including an interior cylindrical bore for mating engagement with the cylindrical outer surface and an inlet conduit 54 communicating with the interior cylindrical bore at a location adjacent the tool holder annular groove 55.

5. A machine according to claim 4, characterised in that the pressure maintaining means comprises a source R of regulated air communicating with the rotary union inlet conduit.
